# EUROPÄISCHE PATENTSCHRIFT

(11) **EP 0 956 580 B1**
(45) Veröffentlichungstag und Bekanntmachung des Hinweises auf die Patenterteilung: **21.04.2004**
(21) Anmeldenummer: 98909378.6
(22) Anmeldetag: 30.01.1998
(51) Int. Cl.: H01J 37/34, H01J 37/32

(54) **VERFAHREN ZUR REGELUNG VON GLIMMENTLADUNGEN MIT PULSFÖRMIGER ENERGIEVERSORGUNG**
AUTOMATIC CONTROL OF GLOW DISCHARGES WITH PULSED ELECTRICAL SUPPLY
PROCEDE DE REGULATION DE DECHARGES LUMINEUSES A ALIMENTATION ELECTRIQUE PAR IMPULSIONS

(30) Priorität: 01.02.1997 DE 19703791
(43) Veröffentlichungstag der Anmeldung: 17.11.1999
(73) Patentinhaber: Fraunhofer-Gesellschaft zur Förderung der angewandten Forschung e.V., 80686 München (DE)
(72) Erfinder: KIRCHHOFF, Volker, D-01324 Dresden (DE); KOPTE, Torsten, D-01157 Dresden (DE); SCHULZE, Matthias, D-01099 Dresden (DE); PETERS, Carsten, D-01127 Dresden (DE)
(86) Internationale Anmeldenummer: PCT/EP1998/000500
(87) Internationale Veröffentlichungsnummer: WO 1998/034267

(56) Entgegenhaltungen:
- EP-A- 0 502 242
- DE-A- 19 605 314
- DE-C- 4 324 683
- PATENT ABSTRACTS OF JAPAN vol. 011, no. 124 (C-416), 17.April 1987 & JP 61 261473 A (TOKUDA SEISAKUSHO LTD), 19.November 1986,
- PATENT ABSTRACTS OF JAPAN vol. 011, no. 268 (C-444), 29.August 1987 & JP 62 070567 A (HITACHI LTD), 1.April 1987,

## Beschreibung

Die Erfindung betrifft ein Verfahren zur Regelung von Glimmentladungen mit pulsförmiger Energieversorgung. Das Verfahren findet in Vakuumprozessen, vorzugsweise bei der Plasmabehandlung von Oberflächen, der Abscheidung von Schichten aus Plasmen und der plasmagestützten Oberflächenreinigung, Anwendung. Insbesondere ist es bei Verwendung von Reaktivgasen zur Abscheidung von Verbindungsschichten geeignet. Derartige Prozesse dienen vorzugsweise zur Oberflächenveredelung von Bauteilen, Werkzeugen, Halbzeugen und Fertigteilen in der Optik, im Maschinenbau, in der Verpackungs-, Glas- und Elektroindustrie. Das Verfahren ist bei PVD- und CVD-Prozessen anwendbar.

Bei der Durchführung von Vakuumprozessen, die plasmagestützt sind und der Verwendung von Materialien mit hoher Affinität zum prozessbedingten Reaktivgas tritt der Effekt ein, dass Teile der Einrichtung mit elektrisch schlecht oder nicht leitenden Materialien beschichtet werden. Das hat zur Folge, dass sich die Prozessparameter ändern oder elektrische Überschläge auftreten. Somit sind diese Prozesse für Beschichtungen oder Oberflächenbehandlungen von Substraten mit hohen Anforderungen an die Qualität ungeeignet.

Es ist allgemein bekannt, dass diese Mängel relativ gut beseitigt werden, indem die Energie der Glimmentladung gepulst zugeführt wird. Weiterhin ist die Stabilisierung eines definierten Plasmazustandes eine grundlegende Voraussetzung für eine reproduzierbare Prozessführung. Es sind eine Vielzahl von Verfahren zur Steuerung von Glimmentladungsprozessen bekannt. Die wesentlichsten Verfahren werden im Folgenden beschrieben.

Es ist bekannt, die optische Plasmaemission zu nutzen. Das Plasma besitzt durch die magnetfeldgeführte Glimmentladung die höchste Anregungs- und damit Emissionswahrscheinlichkeit in Targetnähe. Die Messung muss deshalb in geringem Abstand über der Targetoberfläche erfolgen. Mittels einer Messsonde wird die Plasmaemission gemessen und in einer Messeinheit in ein analoges Spannungssignal umgewandelt. Dieses Spannungssignal wird für die Steuerung genutzt (Schiller et al., "Die optische Plasmaemission", Proc. In-situ Monitoring and Diagnostics of Plasma Processes, Gent (Belgien) 1994). Die Nachteile dieses Verfahrens bestehen darin, dass durch die fortschreitende Targeterosion mit zunehmender Prozessdauer eine Veränderung der örtlichen Verteilung der Plasmadichte eintritt, welche zu einer Veränderung des Emissionssignals führt, da durch die Gestaltung der Messsonde der Plasmazustand im Allgemeinen nur in einem eng begrenzten Raum erfassbar ist. Zusätzlich wird die Messsonde bedingt durch die Targetnähe beschichtet, was ebenfalls zu Beeinflussungen des Prozesses führt. Ein weiterer Nachteil entsteht bei Glimmentladungsprozessen mit hochfrequenter Energieeinspeisung. Durch prozessbedingte hochfrequente Abstrahlungen wird das Spannungssignal gestört, und damit die Auswertung erheblich erschwert.

Es ist weiterhin bekannt, die Steuerung des Prozesses durch Regelung des Reaktivgasflusses in Abhängigkeit vom Reaktivgaspartialdruck durchzuführen (Sproul; Control of a reactive sputtering process for large systems. Proc. of 36th Annual Technical Conference SVC, 1993). Nachteilig ist, dass die Messung direkt am Prozessort durchgeführt werden muss und der apparative Aufwand mittels eines Partialdruckmessgerätes hoch ist. Bei der Messwertbildung ergeben sich große zeitliche Verzögerungen, wodurch eine erforderliche schnelle Regelung nicht erreicht wird.

Es ist bekannt, Vakuumprozesse mit pulsförmiger Energieeinspeisung durch Steuerung der Entladungsspannung zu regeln (DE 41 06 770 C2). Die Entladungsspannung muss an den Elektroden gemessen werden. Daraus wird ein Effektivwert gebildet, der die Impedanzänderung des Prozesses widerspiegelt. Das Verfahren besitzt Nachteile bei reaktiven Vakuumprozessen, in denen Arbeitspunkte zu stabilisieren sind. Bei einigen Targetmaterialien, z.B. Silizium, sind dem analogen Signal hochfrequente Störungen, die durch das Plasma hervorgerufen werden, überlagert. Diese Störungen lassen sich nur sehr schwer erfassen und mit ihrem stochastischen Auftreten, bei gleichzeitig fester Abtast- und Mittelungsrate des analogen Signals, führen sie zu einer Unschärfe des Effektivwertes. Die Zuordnung eines Effektivwertes zu einem entsprechenden Plasmazustand ist problematisch, so dass es zu Verfälschungen kommt, die sich auf den Vakuumprozess auswirken.

Es ist bekannt, Vakuumprozesse mit pulsförmiger Energieeinspeisung durch Abschneiden einzelner Pulse zu steuern, was kurze Unterbrechungen der Energieeinspeisung bewirkt. (WO95/03682) Dies stellt zur Symmetrierung von Glimmentladungen eine vorteilhafte Methode dar. Für die generelle Steuerung der Leistungseinspeisung ist das Verfahren jedoch apparativ aufwendig, da auch bei relativ niedrigen Effektivwerten der eingespeisten Leistung durch den Generator eine hohe Pulsleistung bei unverändert hoher Flankensteilheit bereitgestellt werden muß. Daneben gelten alle bereits erwähnten Nachteile der Prozeßsignalgewinnung für einen derart gesteuerten Betrieb.

Der Erfindung liegt die Aufgabe zugrunde, ein Verfahren zur Regelung von uni- und bipolaren Glimmentladungsprozessen zu schaffen, welches mit geringem apparativen Aufwand und der Verwendung einfacher Bauelemente die Regelung ermöglicht und einen stabilen, definiert geführten Prozess auch bei langen Betriebszeiten störungsfrei gestattet. Das Verfahren soll für PVD- und CVD-Prozesse nutzbar sein.
Erfindungsgemäß wird die Aufgabe mit den Merkmalen des Patentanspruchs 1 gelöst. Weitere Ausgestaltungen sind in den Unteransprüchen 2 bis 7 beschrieben.

Erfindungsgemäß wird zur Regelung von Glimmentladungsprozessen mit pulsförmiger Energieeinspeisung die Steuerung eines Prozessparameters in Abhängigkeit von der Änderung der Pulsfrequenz bzw. der Periodendauer der Energieeinspeisung genutzt.
Diese Änderungen werden durch die Rückwirkung der Impedanz der Glimmentladung auf die Energieversorgung ausgelöst. Die meßbaren Werte von Pulsfrequenz und Periodendauer werden also beim Betrieb des Generators mit einer typischen Plasmalast von den voreingestellten Werten am Generator abweichen.
Überraschend zeigte sich, daß die Änderung der Pulsfrequenz bzw. der Periodendauer in Abhängigkeit der Impedanz ein monotones Verhalten aufweist.
Jeder Prozeßparameter, der in eindeutiger Weise die Impedanz der Glimmentladung beeinflußt, beeinflußt dadurch auch die Frequenz bzw. die Periodendauer der Energieeinspeisung. Die Messung der tatsächlichen Frequenz und die Bestimmung der Abweichung vom voreingestellten Wert bzw. von einem beliebigen Sollwert liefert einen für eine Prozeßsteuerung nutzbaren Wert.
Durch die Steuerung eines solchen in eindeutiger Weise mit der Frequenz der Leistungseinspeisung.verknüpften Prozessparameters der Glimmentladung wird ein definierter Plasmazustand eingestellt, und somit werden gewünschte Schichteigenschaften gezielt erzeugt.
Dazu wird die Pulsfrequenz bzw. die Periodendauer gemessen. Anstelle der Penodendauer kann bei bipolarer Energieeinspeisung auch die Dauer der positiven und/oder negativen Halbwellen jeweils getrennt gemessen werden. Aus diesen gemessenen Größen wird ein Signal gewonnen. Aus diesem Signal werden die Änderungen der gemessenen Größen ermittelt und in Abhängigkeit dieser Änderungen wird mindestens ein Prozessparameter gesteuert.

Der Vorteil des erfindungsgemäßen Verfahrens besteht darin, dass diese Regelung sehr schnell ist, so dass Glimmentladungsprozesse definiert und auch über lange Zeiträume stabil und störungsfrei geführt werden, da Frequenzen in bekannter Weise schnell und mit hoher Genauigkeit auf einfache Art gemessen werden können. Desweiteren lässt sich das gewonnene Signal problemlos übertragen. Hochfrequente Störungen stellen kein Erschwernis dar, da sie sich von dem gewonnenen Signal einfach trennen lassen. Weiterhin ist vorteilhaft, dass die Messung außerhalb des Prozessraumes erfolgt. Die Auswertung und die Verarbeitung des von der Frequenz abhängigen Signals kann in einer separaten Einheit erfolgen. Damit wird zum einen eine Beeinflussung des gewonnenen Signals durch den Prozess ausgeschlossen. Zum anderen wird auch der Vakuumprozess nicht beeinflusst, da keine Messsonden am Prozessort notwendig sind.

Als Prozessparameter werden der Entladungsstrom, die Entladungsspannung, die Entladungsleistung, der Inertgas-Fluss, der Reaktivgas-Fluss oder der Fluss des Inertgas-Reaktivgas-Gemisches, wobei sich das Reaktivgas aus mehreren Komponenten zusammensetzen kann, gesteuert.
Bei bipolaren Glimmentladungsprozessen mit zwei Magnetronelektroden, wobei jede Magnetronelektrode abwechselnd als Katode und Anode geschalten wird, ist es vorteilhaft, die Dauer der positiven und/oder negativen Halbwelle getrennt zu messen.
Entladungsstrom, Entladungsspannung oder Entladungsleistung können dann in Abhängigkeit der Änderungen für jede Halbwelle getrennt gesteuert werden. Der Fluß des Inertgases, des Reaktivgases oder des Inertgas-Reaktivgas-Gemisches können für jede Magnetronelektrode getrennt gesteuert werden.

An einem Ausführungsbeispiel wird die Erfindung näher erläutert. Die zugehörige Zeichnung zeigt dabei eine Einrichtung zum reaktiven Beschichten eines Substrats mit absorptionsfreiem Siliziumdioxid mittels bipolarer Glimmentladung.

In einer Vakuumkammer 1 sind zwei Magnetronelektroden 2a, 2b mit je einem nicht gezeichneten Target aus Silizium, das zerstäubt wird, angeordnet. Unterhalb der Magnetronelektroden 2a, 2b ist ein zu beschichtendes Substrat 3 angeordnet.
In die Vakuumkammer 1 wird über einen Gaseinlaß 4 ein Gemisch aus Argon als inertgas und Sauerstoff als Reaktivgas eingelassen. Der Arbeitsdruck beträgt ca. 0,3 Pa. Ein Sinusgenerator 5 mit einer Nennleistung von 100 kW zur pulsförmigen Energieeinspeisung arbeitet im Frequenzbereich von 20 bis 100 kHz. Die beiden durch den Sinusgenerator 5 gespeisten Magnetronelektroden 2a, 2b arbeiten wechselseitig als Anode und Katode. Mit Hilfe einer Messeinrichtung 6 erfolgt die Messung der Periodendauer. Das in der Messeinrichtung 6 aus der Periodendauer gewonnene Signal wird als Regelgröße verwendet. Aus dem Vergleich eines vorgegebenen Sollwertes mit dem gewonnenen Signal wird in geeigneter Weise ein Differenzsignal gebildet. Mit dem Differenzsignal wird mittels eines Reglers 7 der Sauerstoff-Fluss derart gesteuert, dass der Glimmentladungsprozess zur Abscheidung einer Schicht aus absorptionsfreiem Siliziumdioxid dauerhaft stabilisiert wird.

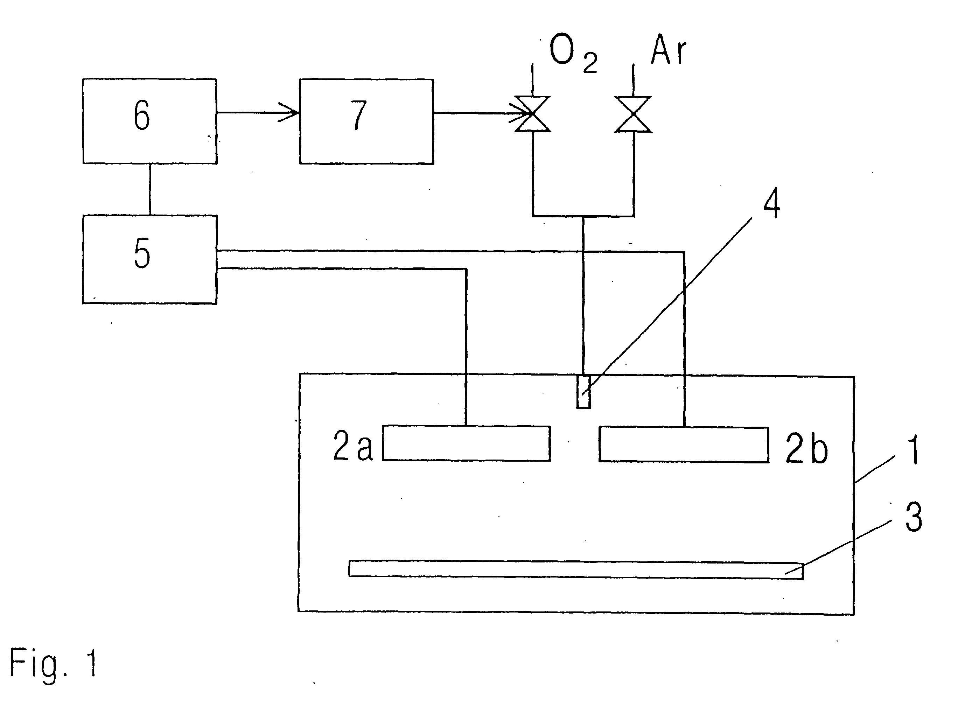

## Patentansprüche

1. Verfahren zur Regelung von Glimmentladungsprozessen mit pulsförmiger Energieeinspeisung in mindestens zwei Elektroden (2a; 2b) durch Steuerung eines Prozessparameters mittels eines Regelkreises, **dadurch gekennzeichnet, dass** die Pulsfrequenz oder die Periodendauer oder die Dauer der einzelnen positiven und/oder negativen Halbwellen der eingespeisten Energie außerhalb der Beschichtungszone gemessen werden, dass aus diesen gemessenen Größen ein Signal gewonnen wird, dass aus dem Vergleich des gewonnenen Signals mit einem vorgegebenen Sollwert der jeweiligen Größe ein Differenzsignal gebildet wird, und damit mindestens ein Prozessparameter der Glimmentladung geregelt wird.

2. Verfahren nach Anspruch 1, **dadurch gekennzeichnet, dass** als Prozessparameter der Inertgas-Fluss gesteuert wird.

3. Verfahren nach Anspruch 1, **dadurch gekennzeichnet, dass** als Prozessparameter der Reaktivgas-Fluss gesteuert wird.

4. Verfahren nach Anspruch 1, **dadurch gekennzeichnet, dass** als Prozessparameter der Fluss eines Inertgas-Reaktivgas-Gemisches gesteuert wird.

5. Verfahren nach Anspruch 1, **dadurch gekennzeichnet, dass** als Prozessparameter der Entladungsstrom gesteuert wird.

6. Verfahren nach Anspruch 1, **dadurch gekennzeichnet, dass** als Prozessparameter die Entladungsspannung gesteuert wird.

7. Verfahren nach Anspruch 1, **dadurch gekennzeichnet, dass** als Prozessparameter die Entladungsleistung gesteuert wird.

## Claims

1. Method for the automatic control of glow discharge processes with pulsed energy feeding into at least two electrodes (2a; 2b) by controlling a process parameter by means of a control loop, **characterized in that** the pulse frequency or the period or the duration of the individual positive and/or negative half-waves of the energy fed in is measured outside the coating zone, **in that** a signal is obtained from these measured variables, **in that** a differential signal is formed from the comparison of the signal obtained with a predetermined setpoint value of the respective variable and is used for automatically controlling at least one process parameter of the glow discharge.

2. Method according to Claim 1, **characterized in that** the inert-gas flow is controlled as a process parameter.

3. Method according to Claim 1, **characterized in that** the reactive-gas flow is controlled as a process parameter.

4. Method according to Claim 1, **characterized in that** the flow of an inert-gas/reactive-gas mixture is controlled as a process parameter.

5. Method according to Claim 1, **characterized in that** the discharge current is controlled as a process parameter.

6. Method according to Claim 1, **characterized in that** the discharge voltage is controlled as a process parameter.

7. Method according to Claim 1, **characterized in that** the discharge power is controlled as a process parameter.

## Revendications

1. Procédé pour régler des processus de décharge lumineuse, dont l'alimentation en énergie est pulsée, dans au moins deux électrodes (2a ; 2b) en commandant un paramètre de processus à l'aide d'un circuit régulateur,
**caractérisé en ce qu'**
à l'extérieur de la zone de revêtement on mesure la fréquence d'impulsion ou la durée de la période ou la durée des demi-ondes particulières positives et/ou négatives de l'alimentation en énergie, on obtient un signal à partir de ces grandeurs mesurées, on forme un signal différentiel dont la valeur théorique de la grandeur concernée est prédéterminée à partir de la comparaison du signal obtenu et on règle par son aide au moins un paramètre de processus de la décharge lumineuse.

2. Procédé selon la revendication 1,
**caractérisé en ce que**
comme paramètre de processus, on commande le débit de gaz inerte.

3. Procédé selon la revendication 1,
**caractérisé en ce que**
comme paramètre de processus, on commande le débit de gaz réactif.

4. Procédé selon la revendication 1,
**caractérisé en ce que**
comme paramètre de processus, on commande le débit d'un mélange de gaz inerte et de gaz réactif.

5. Procédé selon la revendication 1,
**caractérisé en ce que**
comme paramètre de processus, on commande le courant de décharge.

6. Procédé selon la revendication 1,
**caractérisé en ce que**
comme paramètre de processus, on commande la tension de décharge.

7. Procédé selon la revendication 1,
**caractérisé en ce que**
comme paramètre de processus, on commande la puissance de décharge.
